# EUROPEAN PATENT SPECIFICATION

(11) **EP 2 927 740 B1**
(45) Date of publication and mention of the grant of the patent: **26.12.2018**
(21) Application number: 15161001.1
(22) Date of filing: 26.03.2015
(51) Int. Cl.: G02F 1/1333

(54) **CURVED DISPLAY DEVICE**
GEBOGENE ANZEIGEVORRICHTUNG
DISPOSITIF D'AFFICHAGE INCURVÉ

(30) Priority: 01.04.2014 KR 20140038734
(43) Date of publication of application: 07.10.2015
(73) Proprietor: Samsung Display Co., Ltd., Gyeonggi-do (KR)
(72) Inventor: Park, Jong-Myeong, 113-1101 Asan-si, Chungcheongnam-ro (KR); Lee, Cheolse, 106-101 Daegu (KR); Yang, Sang Sik, Cheonan-si, Chungcheongnam-do Cheonan-si, Chungcheongnam-do (KR); Choi, Seongsik, 30-1011 Seoul (KR); Kim, Tae-Sung, 427-22 Bucheon-si, Gyeonggi-do (KR); Shim, Kyu-Hun, 506-712 Seoul (KR)
(74) Representative: Dr. Weitzel & Partner

(56) References cited:
- EP-A1- 2 664 957

## Description

### BACKGROUND

Embodiments of the present invention are directed to a curved display device, and more particularly, to a curved display device having a curved display area.

Flat panel display devices can be used for displaying images in television sets, monitors, laptop computers, mobile phones, etc. Recently, there has been an increase in demand for curved display devices having a curved surface and capable of allowing users to view the images in 3D or experience the feelings of immersion, and telepresence. EP 2 664 957 discloses a curved display device comprising a plurality of curved portions arranged next to each other, the curvature of the outer portions being different from that of the center portion.

### SUMMARY

One aspect of embodiments of the present invention is directed to a curved display device having improved display quality, as recited in appended independent claim 1. Other aspects of the invention are recited in the appended dependent claims.

### BRIEF DESCRIPTION OF THE DRAWINGS

The above and other objects and features will become more apparent from the following description in conjunction with the following drawings, wherein like reference numerals refer to like parts throughout the drawings and specification, unless otherwise specified, and wherein:
Fig. 1A is a perspective view illustrating a curved display device according to an embodiment of the present invention;
Fig. 1B is a top view of the curved display device of Fig. 1A;
Fig. 1C is a side view of the curved display device of Fig. 1A;
Fig. 2A is a disassembled perspective view illustrating the curved display device of Fig. 1A;
Fig. 2B is a sectional view taken along line I-I' of Fig. 2A;
Fig. 3A is an expanded view of the display panel of Fig. 2A;
Fig. 3B is a side view of the display panel of Fig. 3A;
Figs. 4A and 4B illustrate luminance patterns respectively present in regions of a display area in a comparative curved display device;
Figs. 4C and 4D illustrate luminance patterns respectively present in regions of a display area in a curved display device according to one or more embodiments of the present invention;
Fig. 5 is a disassembled perspective view illustrating how the display panel, the supporter, and the cover can be combined;
Fig. 6A is a perspective view illustrating a display panel of a curved display device not according to the invention and Fig. 6B is a side view illustrating the display panel of Fig. 6A;
Fig. 7A is a disassembled perspective view illustrating how a display panel, a supporter, and a cover in a curved display device according to another embodiment of the present invention can be combined;
Fig. 7B is a sectional view taken along line II-II' of Fig. 7A;
Fig. 8A is a disassembled perspective view illustrating how a display panel, a supporter, and a cover in a curved display device according to another embodiment of the present invention can be combined;
Fig. 8B is a sectional view taken along line III-III' of Fig. 8A; and
Fig. 9 is a perspective view illustrating a display panel of a curved display device according to another embodiment of the present invention.

### DETAILED DESCRIPTION

In the following detailed description, embodiments will be described with reference to the accompanying drawings. However, the present invention may be embodied in various different forms, and should not be construed as being limited only to the illustrated embodiments. Rather, these embodiments are provided as examples, simply by way of illustrating the concept of the present invention to those skilled in the art. Accordingly, processes, elements, and techniques that should be apparent to those of ordinary skill in the art are not described herein. Unless otherwise noted, like reference numerals denote like elements throughout the drawings and specification. In the drawings, the sizes and relative sizes of layers and regions may be exaggerated for clarity.

It will be understood that, although the terms "first", "second", "third", etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the scope of embodiments of the present invention.

Spatially relative terms, such as "beneath", "below", "lower", "under", "above", "upper" and the like may be used herein for ease of description to describe one element or feature's relationship to another element(s) or feature(s) as illustrated in the figures. It will be understood that the spatially relative terms are intended to encompass different orientations of the device (e.g., in use or operation), in addition to the orientation depicted in the figures. For example, elements initially described as "below" or "beneath" or "under" other elements or features can be described as "above" the other elements or features, if the device in the figures is turned over. Thus, the exemplary terms "below" and "under" can encompass orientations of both above and below. The device may be otherwise oriented in various directions (e.g. rotated 90 degrees or at other orientations) and the spatially relative descriptors used herein may be interpreted accordingly. In addition, it will also be understood that when a layer is referred to as being "between" two layers, it can be the only layer between the two layers, or one or more intervening layers may also be present.

The terminology used herein is for the purpose of describing particular embodiments only and is not intended to be limiting the scope of the present invention. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. Also, the term "exemplary" is intended to refer to an example or illustration. Further, the use of "may" when describing embodiments of the present invention refers to "one or more embodiments of the present invention."

It will be understood that when an element or layer is referred to as being "on", "connected to", "coupled to", or "adjacent to" another element or layer, it can be directly on, connected, coupled, or adjacent to the other element or layer, or intervening elements or layers may be present. In contrast, when an element is referred to as being "directly on," "directly connected to", "directly coupled to", or "immediately adjacent to" another element or layer, there are no intervening elements or layers present.

Unless otherwise defined, all terms (including technical and scientific terms) used herein have the same meaning as commonly understood by those of ordinary skill in the art of embodiments of the present invention. It will be further understood that terms, such as those defined in commonly used dictionaries, should be interpreted as having a meaning that is consistent with their meaning in the context of the relevant art and/or the present specification and will not be interpreted in an idealized or overly formal sense unless expressly so defined herein.

Hereinafter, embodiments of the present invention will be described in conjunction with the accompanying drawings.

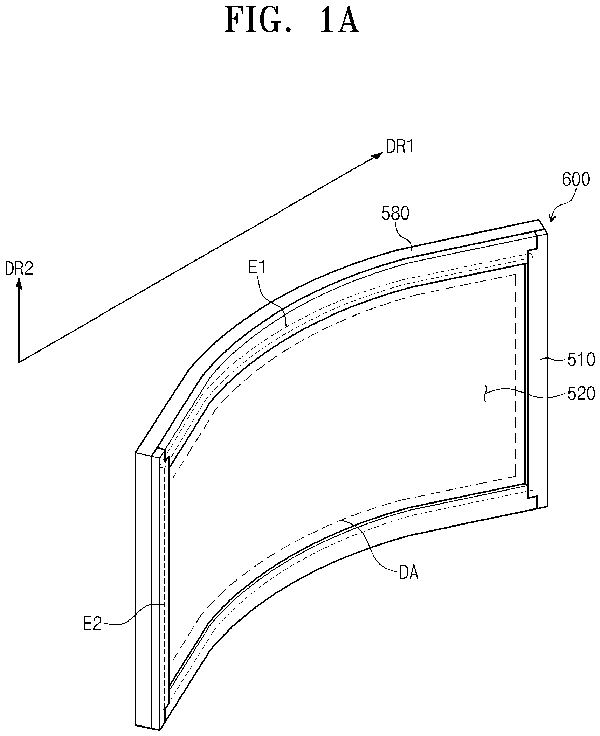

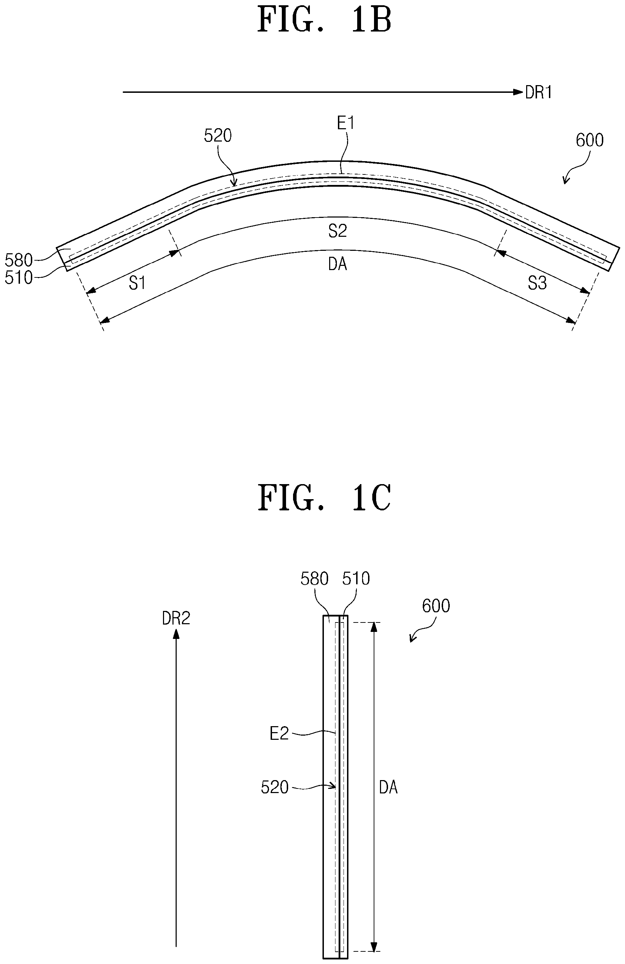

Fig. 1A is a perspective view illustrating a curved display device according to one embodiment of the present invention, Fig. 1B is a top view of the curved display device of Fig. 1A, and Fig. 1C is a side view of the curved display device of Fig. 1A.

Referring to Figs. 1A, 1B and 1C, a curved display device 600 is partly curved (e.g., concave) along a first direction DR1. The resulting display area DA is partly curved as well, corresponding to the curve of the curved display device 600. In one embodiment, the side of the curved display device 600 sequentially includes a first segment S1, a second segment S2, and a third segment S3. In one embodiment, the second segment S2 is curved while each of the first and third segments S1 and S3 is shaped in a straight line. Accordingly, regions of the display area DA corresponding to the first and third segments S1 and S3 may be flat, while the region of the display area DA corresponding to the second segment S2 may be curved.

Although in this embodiment the display area DA is illustrated as concave, in another embodiment the display area DA may be convex.

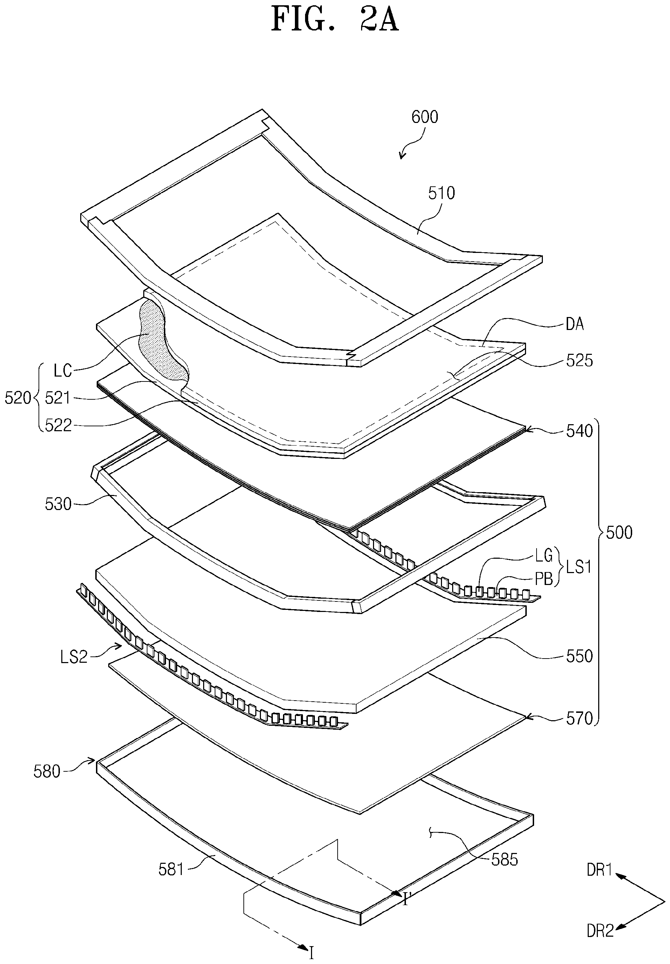

In one embodiment, the curved display device 600 includes an accommodation member 580, a display panel 520, a supporter 530, and a cover 510. In this embodiment, the display panel 520 may be a liquid crystal display (LCD) panel. When the display panel 520 is an LCD, the curved display device 600 may further include a backlight assembly (element 500 in Fig. 2A), which is inserted into the accommodation member 580 and functions to emit light toward the display panel 520.

However, embodiments of the present invention are not limited thereto and may include different kinds of display panels such as, for example, organic electric-field light emission display panels or nano-crystal display panels.

In one embodiment, similar to the curved display device 600, the display panel 520 may be partly curved (e.g. concave) along the first direction DR1. In one embodiment, the region of the display panel 520 corresponding to the second segment S2 may be curved, while regions of the display panel 520 corresponding to the first and third segments S1 and S3 may be respectively flat.

In one embodiment, the first through third segments S1, S2 and S3 may be sequentially positioned along a long side E1 of the display panel 520. Accordingly, the long side E1 can be partly curved along the first direction DR1. A short side E2 of the display panel 520 may be extend along a second direction DR2 in a straight line. The second direction DR2 may intersect the first direction DR1 and may be perpendicular to the first direction DR1.

In one embodiment, the accommodation member 580 houses the display panel 520. The cover 510 may be coupled with the accommodation member 580 and may include an opening corresponding to the display area DA so as to cover the border of the display panel 520. Accordingly, the border of the display panel 520 may be covered by the cover 510, while the display area DA may be exposed to the outside.

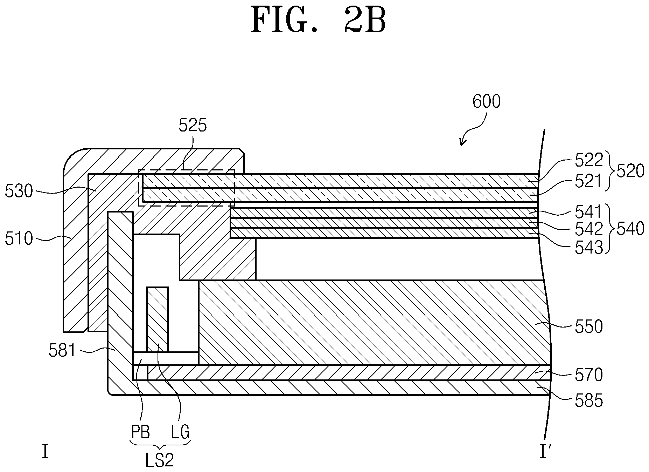

Fig. 2A is a disassembled perspective view illustrating of the curved display device shown in Fig. 1A, and Fig. 2B is a sectional view taken along line I-I' of Fig. 2A.

As illustrated in Figs. 2A and 2B, the curved display device 600 includes the display panel 520, the backlight assembly 500, the accommodation member 580, the supporter 530, and the cover 510.

In one embodiment, the display panel 520 includes a first substrate 521, a second substrate 522, and a liquid crystal layer LC between the first and second substrates 521 and 522. In this embodiment, a plurality of pixels may be arranged on the first substrate 521. Each pixel may include a pixel electrode and a thin film transistor for switching a drive signal to the pixel electrode. Additionally, a common electrode and a color filter may be positioned on the second substrate 522. The common electrode generates an electric field, which may be applied onto the liquid crystal layer LC along with the plurality of pixel electrodes, and the color filter filters light emitted from the backlight assembly 500 into a color light.

While this embodiment has been illustrated to have the aforementioned structure, embodiments of the present invention are not limited thereto. For instance, in other embodiments, the color filter may be on the second substrate 522, and the common electrode may be on the first substrate 521 together with the pixel electrodes.

In one embodiment, the first and second substrates 521 and 522 may each be a kind of a glass substrate, but the first and second substrates 521 and 522 are not limited thereto and may be plastic substrates, such as polyimide substrates.

In one embodiment, the backlight assembly 500 is housed in the accommodation member 580 and emits light toward the display panel 520. Hereinafter an exemplary structure of the backlight assembly 500 for the curved display device 600 will be described.

The backlight assembly 500 may include a first light emission unit LS1, a second light emission unit LS2, a light guiding plate 550, a reflection plate 570, and a plurality of sheets 540.

In one embodiment, the first and second light emission units LS1 and LS2 generate light. In this embodiment, each of the first and second light emission units LS1 and LS2 may include a printed circuit board PB, and a plurality of light emission diode (LED) packages LG mounted on the printed circuit board PB to generate light. The first light emission unit LS1 may be adjacent to a first side of the light guiding plate 550, while the second light emission unit LS2 may be adjacent to a second side of the light guiding plate 550 opposite to the first side. Accordingly, light generated from the first and second light emission units LS1 and LS2 may be incident on the light guiding plate 550 from both sides of the light guiding plate 550, and the light guiding plate 550 may lead this incident light into the display panel 520.

In one embodiment, the reflection plate 570 is positioned between the light guiding plate 550 and a bottom 585 of the accommodation member 580, and contains a material capable of reflecting light, such as, for example, polyethylene terephthalate (PET) or aluminum. The reflection plate 570 may reflect the light emitted from the first and second light emission units LS1 and LS2 toward the light guiding plate 550.

In one embodiment, the plurality of sheets 540 are positioned between the display panel 520 and the light guiding plate 550. The plurality of sheets 540 may include a spread sheet 543, a prism sheet 542, and a protection sheet 541. In one embodiment, the spread sheet 543 acts to spread out light that is emitted from the light guiding plate 550, the prism sheet 542 concentrates the light emitted from the light guiding plate 550, and the protection sheet 541 has the non-optical characteristics and is capable of protecting the back of the display panel 520.

While in this embodiment the backlight assembly 500 is illustrated to have the aforementioned structure, embodiments of the present invention are not limited thereto. For instance, in another embodiment, instead of removing the light guiding plate 550 from the backlight assembly 500, a plurality of LED packages may be arranged in a matrix on the bottom 585 of the accommodation member 580 and a spread plate may be placed between the plurality of LED packages and the display panel 520.

In one embodiment, the accommodation member 580 defines an accommodation space into which the backlight assembly 500 is inserted. The accommodation member 580 may include the bottom 585 and a plurality of sidewalls 581 extending from the bottom 585. In one embodiment, the accommodation member 580 may extend along the first direction DR1, and may be curved along the first direction DR1 to correspond to the curvature of the display panel 520.

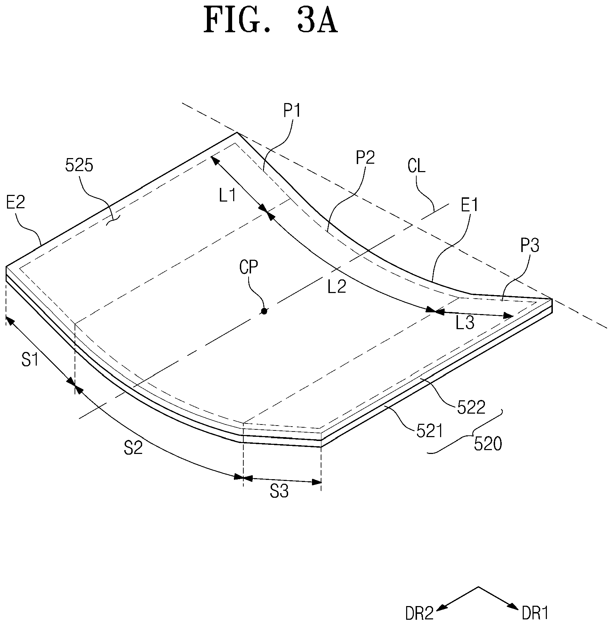

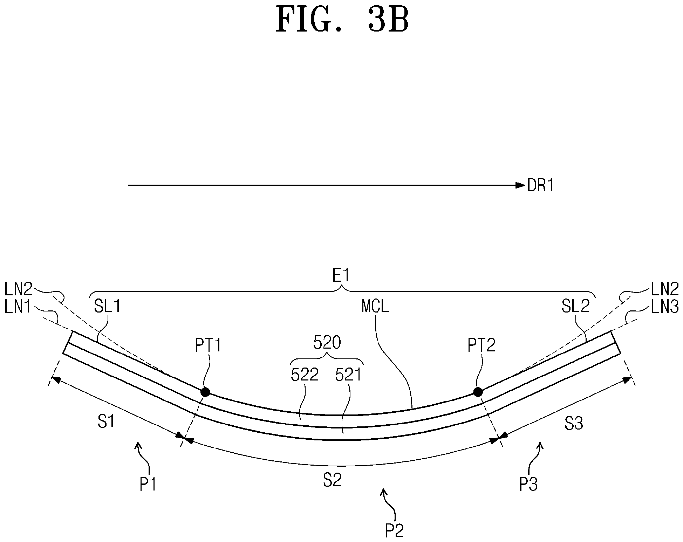

In one embodiment, the supporter 530 is around and covering an edge 525 of the display panel 520 and is coupled to the sidewalls 581 of the accommodation member 580. Accordingly, the supporter 530 is coupled with the display panel 520, and may physically support the edge 525 of the display panel 520. In one embodiment, the cover 510 covers the edge 525 of the display panel 520 and is coupled with the supporter 530. As a result, the cover 510 can support the edge 525 of the display panel 520 together with the supporter 530. In one embodiment, the cover 510 contacts the top surface of the edge 525 to support the edge 525, while the supporter 530 contacts the bottom of the edge 525 to support the edge 525. Accordingly, the cover 510 and the supporter 530 together may sustain the specific shape of the display panel 520. This embodiment will be further described with reference to Figs. 3A and 3B.

Fig. 3A is an expanded view of the display panel shown in Fig. 2A, and Fig. 3B is a side view of the display panel shown in Fig. 3A.

Referring to Figs. 3A and 3B, in the display panel 520 of this embodiment, the long side E1 extends along the first direction DR1 and is partly curved (e.g. concave) along the first direction DR1 and the short side E2 extends along the second direction DR2 that is perpendicular to the first direction DR1.

In one embodiment, the long side E1 is only partially curved, as the display panel 520 may include both curved and flat parts. In other words, the display panel 520 may include a first flat portion P1 corresponding to the first segment S1, a curved portion P2 corresponding to the second segment S2, and a second flat portion P3 corresponding to the third segment S3.

In one embodiment, the long side E1 may consist of a first straight line SL1 in the first segment S1, a second straight line SL2 in the third segment S3, and a middle curved line MCL in the second segment S2. Accordingly, the first straight line SL1 and the second straight line SL2 are straight lines, and the middle curved line MCL has a curvature.

In one embodiment, a first imaginary line LN1 is extending from the outer end of the first straight line SL1, a third imaginary line LN3 is extending from the outer end of the second straight line SL2, and a second imaginary line (an imaginary curved line) LN2 is defined as extending from both ends of the middle curved line MCL. In this embodiment, the first and third imaginary lines LN1 and LN3 are linear and the second imaginary line LN2 has a curvature.

In one embodiment, the middle curved line MCL may have a curvature radius of 1m to 10m. Accordingly, the curved portion P2 of the display panel 520 may have a curvature radius of 1m to 10m, corresponding to the middle curved line MCL.

In one embodiment, the middle curved line MCL and the first straight line SL1 meet at a first point PT1, and the middle curved line MCL and the second straight line SL2 meet at a second point PT2. Accordingly, the first straight line SL1 may be tangent to the middle curved line MCL and the second imaginary line LN2 at the first point PT1 between the middle curved line MCL and the second imaginary line LN2. Similarly, the second straight line SL2 may be tangent to the middle curved line MCL and the second imaginary line LN2 at the second point PT2 between the middle curved line MCL and the second imaginary line LN2, opposite the first point PT1.

In contrast to the embodiments of the present invention, if the first and second straight lines SL1 and SL2 were at an angle to the middle curved line MCL and the second imaginary line LN2 respectively, and not tangential, physical stress can be concentrated on the display panel 520 at the positions where the first and second straight lines SL1 and SL2 meet the middle curved line MCL respectively. However, in one embodiment of the present invention, since the first and second straight lines SL1 and SL2 are tangent to the middle curved line MCL and the second imaginary line LN2 respectively, physical stress, which can result from being locally weighted down to the display panel 520 in correspondence with the positions of the first and second points PT1 and PT2, may be prevented (or reduced).

In one embodiment, the display panel 520 has a center point CP and an imaginary center line CL passing through the center point CP. The display panel 520 may be symmetrical with respect to the center line CL, and the first flat portion P1 may be symmetrical with respect to the second flat portion P3, with the curved portion P2 between the first and second flat portions P1 and P3. In one embodiment, a first length L1 is the length of the first segment S1 in the first direction DR1, a second length L2 is the length of second segment S2 in the first direction DR1, and a third length L3 is the length of the third segment S3 in the first direction DR1, and the first length L1 may be the same as the third length L3.

In contrast to the embodiments of the present invention, if the entire surface of the display panel 520 is uniformly bent in a shape of a parabola, physical stress can be concentrated at the edge 525 of the display panel 520, to support the curve of the first and third segments S1 and S3. Therefore, when light emitted from the backlight assembly (element 500 of Fig. 2A) is transmitted through the edges 525 of the first and second substrates 521 and 522 included in the display panel 520, a refraction ration (i.e. the difference in the refractive indices of the material) can be facilitated by propagation directions of the light, thus resulting in optical retardation of the light. In other words, the stress concentrated on the edges 525 can induce retardation of the light in the first and second substrates 521 and 522. Therefore, it may be difficult to achieve uniform luminance throughout the display area of the display panel 520, since regions adjacent to the edges 525 in the display area (i.e. peripheral regions) can be different (optically) from the central regions. However, in embodiments of the present invention, the first and second flat portions P1 and P3 included in the display panel 520 and corresponding to the first and third segments S1 and S3 respectively, may contribute to reducing physical stress exerted on the edges 525. Consequently, the retardation of light transmitted through the edges 525 can be prevented (or reduced), and non-uniformity of luminance that may occur in the display area due to the retardation of the light can be minimized (or reduced).

In one embodiment, even though the first and third segments S1 and S3 are linear, some luminance non-uniformity may still be present in the display area DA of the display panel 520. To reduce such luminance non-uniformity, it may be helpful to optimize occupation ratios of the first and third segments S1 and S3 relative to the first through third segments S1, S2, S3. When the display panel 520 has optimal (or satisfactory) occupation ratios of the first and third segments S1 and S3, the intensity of physical stress concentrated at the edges 525 can be minimized (or reduced) to prevent (or reduce) non-uniformity of luminance throughout the display area.

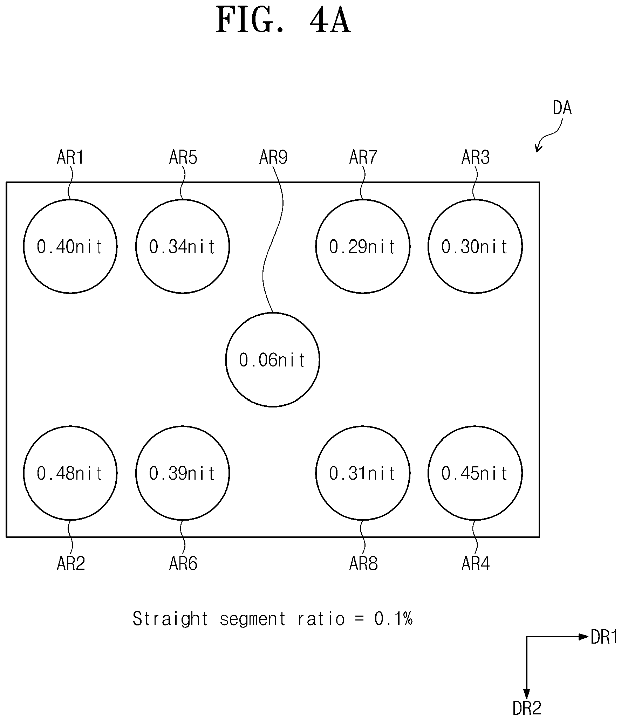

In one embodiment, the each ratio of the first and third lengths L1 and L3 to a sum of the first through third lengths L1, L2, L3 is defined as a straight segment ratio, and the straight segment ratio may be about 1% to about 35%. In another embodiment, the straight segment ratio may be about 10% to about 25%. If the straight segment ratio is less than 1% or greater than 35%, a light source with luminance higher than 0.20nit can appear on the display area and cause black spots, thus deteriorating display quality of an image. Luminance patterns with respect to one embodiment of the present invention will be described with reference to Figs. 4A through 4D.

Table 1 summarizes optimal values of the straight segment ratio for different sizes of the display area.

**Table 1**

| Display area size [inch] | Sum of 1st to 3rd lengths [mm] | 1st length [mm] | 2nd length [mm] | 3rd length [mm] | Straight segment ratio [%] |
|---|---|---|---|---|---|
| 48 | 1054 | 167 | 720 | 167 | 15.8 |
| 55 | 1210 | 191 | 828 | 191 | 15.8 |
| 60 | 1330 | 210 | 910 | 210 | 15.8 |
| 65 | 1428 | 226 | 976 | 226 | 15.8 |
| 70 | 1549 | 245 | 1059 | 245 | 15.8 |
| 75 | 1650 | 261 | 1128 | 261 | 15.8 |
| 85 | 1872 | 297 | 1284 | 297 | 15.8 |
| 98 | 2159 | 342 | 1475 | 342 | 15.8 |
| 105 | 2450 | 389 | 1672 | 389 | 15.8 |

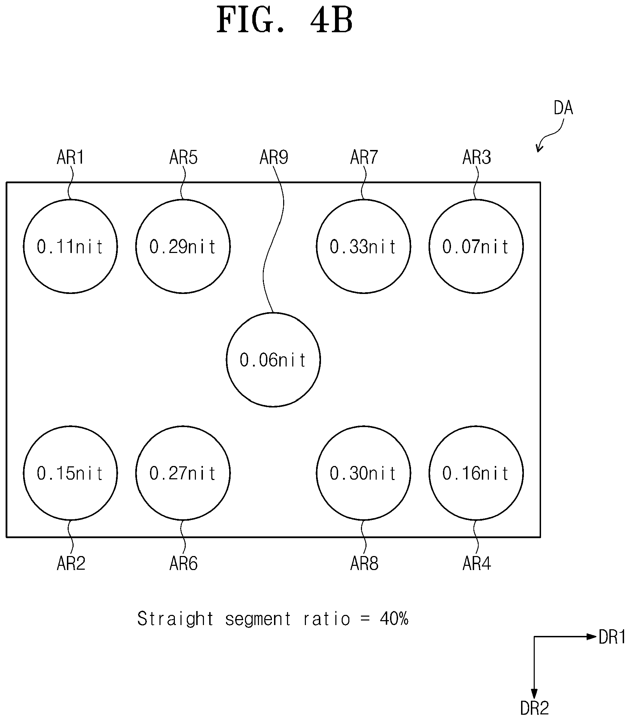

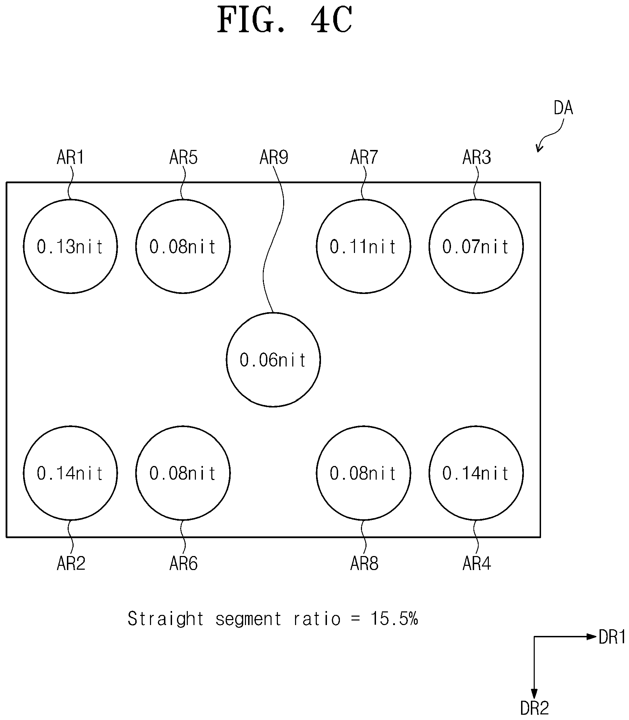

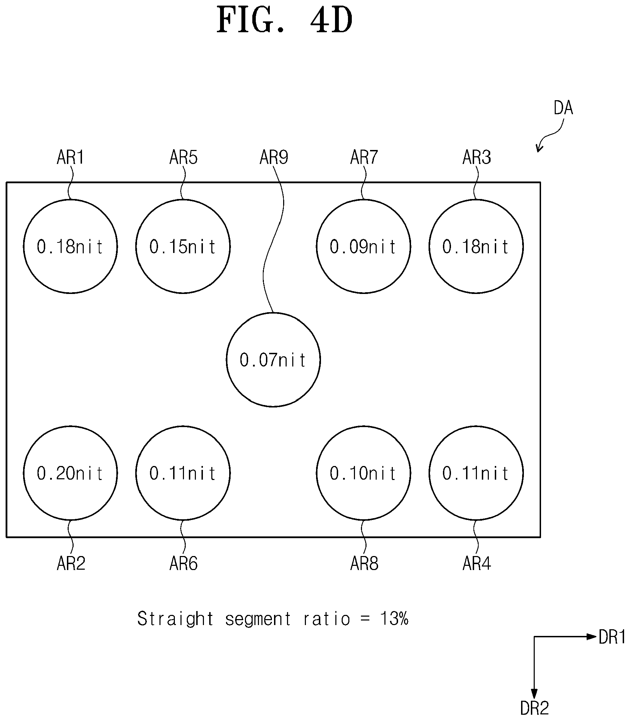

Figs. 4A and 4B illustrate luminance patterns in regions of the display area of a comparative curved display device, and Figs. 4C and 4D illustrate luminance patterns in regions of the display area of a curved display device according to embodiments of the present invention.

Referring to Fig. 4A, if the straight segment ratio is 0.1%, luminance (unit of measurement: nit) of the display area DA displaying black is indicated for each of first through ninth areas AR1 to AR9. The first and second areas AR1 and AR2 are positioned in the top and bottom corners of a first side (e.g. left side) of the display area DA respectively; the third and fourth areas AR3 and AR4 are positioned in the top and bottom corners of a second side (e.g. right side) of the display area DA, opposite the first side; the ninth area AR9 is positioned in the center of the display area DA; the fifth and sixth areas AR5 and AR6 are positioned between the center and the first side of the display area DA; and the seventh and eighth areas AR7 and AR8 are positioned between the center and the second side of the display area DA.

As illustrated in Fig. 4A, average luminance of the first and second areas AR1 and AR2 is about 0.44nit; average luminance of the third and fourth areas AR3 and AR4 is about 0.38nit; and average luminance of the fifth through eighth areas AR5 ∼ AR8 is about 0.33nit. Accordingly, the average luminance of the first through eighth areas AR1 to AR8 is about 0.37nit, not including the ninth area AR9 with luminance of 0.06nit.

In one embodiment, a part of the display area DA having luminance over 0.20nit is defined as a light source. Accordingly, each of the first through eighth areas AR1 to AR8 is the light source, as luminance of each the first through eighth area AR1 to AR8 is over 0.20nit. As a result of the display area DA having such light sources, display quality of images in the display area DA can deteriorate.

Referring to Fig. 4B, if the straight segment ratio is 40%, luminance (unit of measurement: nit) of the display area DA displaying black is indicated for each of the first through ninth areas AR1 to AR9. As illustrated in Fig. 4B, while luminance of each of the first through fourth areas AR1 to AR4 is less than 0.20nit, luminance of each of the fifth through eighth areas AR5 to AR8 is greater than 0.20nit. Accordingly, fifth through eighth areas AR5 to AR8 can be light sources and thus, can deteriorate display quality of images on the display area DA.

Based on the results shown in Figs. 4A and 4B, and without being bound by any particular theory, it is believed that if the straight segment ratio is less than 1% or greater than 35%, light sources can appear on the display area DA and may cause black spots. If the straight segment ratio is less than 1%, areas where the light sources are appearing in the display area DA can be near both edges of the display area DA. If the straight segment ratio is greater than 35%, areas where the light sources are appearing in the display area DA can be located towards the center of the display area DA.

Referring now to Fig. 4C, if the straight segment ratio is 15.5%, luminance (in nit) of the display area DA displaying black is illustrated for each of the first through ninth areas AR1 to AR9. As illustrated in Fig. 4C, luminance of each of the first through ninth areas AR1 to AR9 may be less than 0.20nit, which is less than the luminance required for a region of the display area to be defined as a light source, as discussed above. Accordingly, since the appearance of light sources on the display area DA may be reduced, it is possible to improve display quality of images on the display area DA.

Referring to Fig. 4D, if the straight segment ratio is 13%, luminance (in nit) of the display area DA displaying black is illustrated for each of the first through ninth areas AR1 to AR9. Since luminance of each of the first through ninth areas AR1 to AR9 is less than 0.20nit, a light source does not appear on the display area DA, and display quality of images on the display area DA may be improved.

Without being bound by any particular theory, it is believed that generation of light sources can be prevented or reduced when the straight segment ratio of a display panel is within the range from about 1% to about 35%. Additionally, although in embodiments of the present disclosure the reference level of luminance required for a region of the display area to be defined as a light source is set at 0.20nit, the straight segment ratio capable of preventing or reducing generation of light sources may stay in the range from about 1% to about 35% even if the reference level of luminance is modified. For example, if the reference level of luminance is less than 0.20nit, the straight segment ratio may be in a range of about 10% to about 25%.

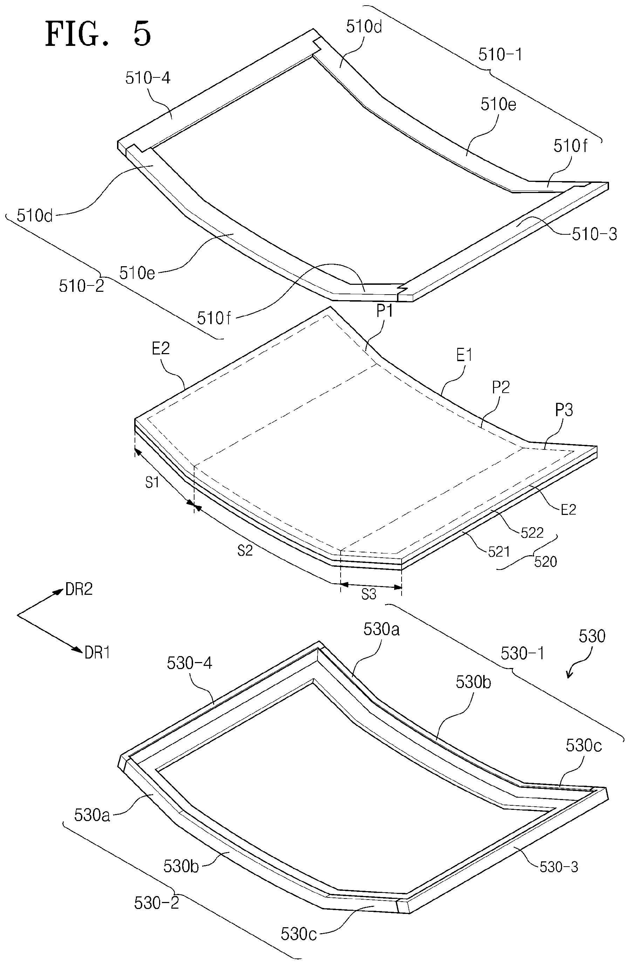

Fig. 5 is a disassembled perspective view illustrating how the display panel, the supporter, and the cover can be combined.

Referring to Fig. 5, the cover 510 and the supporter 530 are coupled with the display panel 520, thus supporting the configuration of the display panel 520. In one embodiment,, the cover 510 and the supporter 530 may be shaped to correspond to the configuration of the display panel 520 in each of the first through third segments S1, S2, S3.

In this embodiment, the supporter 530 includes a first support member 530-1, a second support member 530-2, a third support member 530-3, and a fourth support member 530-4. The first and second support members 530-1 and 530-2 may support edges of the display panel 520 along the long sides E1, while the third and fourth support members 530-3 and 530-4 may support edges of the display panel 520 along the short sides E2.

In the embodiment where the supporter 530 has this structure, the third and fourth support members 530-3 and 530-4 may each extend along the second direction DR2 in accordance with the pattern of the short side E2 of the display panel 520, while the first and second support members 530-1 and 530-2 may each extend along the first direction DR1 and may be partly curved (e.g. concave) along the first direction DR1, in accordance with the pattern of the long side E1 of the display panel 520.

In one embodiment, each of the first and second support members 530-1 and 530-2 includes a first frame 530a corresponding to the first segment S1, a second frame 530b corresponding to the second segment S2, and a third frame 530c corresponding to the third segment S3. The first and third frames 530a and 530c may be flat and may correspond in shape to the first and second flat portions P1 and P3 respectively. The second frame 530b may be curved and may correspond in shape to the curved portion P2. In this embodiment, curvature radius of the second frame 530b may be identical to that of the curved portion P2.

The cover 510 may be partly curved, like the supporter 530. In one embodiment, the cover 510 includes a first cover member 510-1, a second cover member 510-2, a third cover member 510-3, and a fourth cover member 510-4. The first and second cover members 510-1 and 510-2 respectively cover the long sides E1 of the display panel 520, while the third and fourth cover members 510-3 and 510-4 respectively cover the short sides E2.

The third and fourth cover members 510-3 and 510-4 may each extend along the second direction DR2 in accordance with the pattern of the short side E2 of the display panel 520, while the first and second cover members 510-1 and 510-2 may be partly curved (e.g. concave) along the first direction DR1, in accordance with the pattern of the long side E1 of the display panel 520.

In one embodiment, each of the first and second cover members 510-1 and 510-2 includes a fourth frame 510d corresponding to the first segment S1, a fifth frame 510e corresponding to the second segment S2, and a sixth frame 510f corresponding to the third segment S3. In one embodiment, the fourth and sixth frames 510d and 510f are flat and correspond in shape to the first and second flat portions P1 and P3 respectively,, and the fifth frame 510e is curved and corresponds in shape to the curved portion P2. In this embodiment, curvature radius of the fifth frame 510e may be identical to that of the curved portion P2.

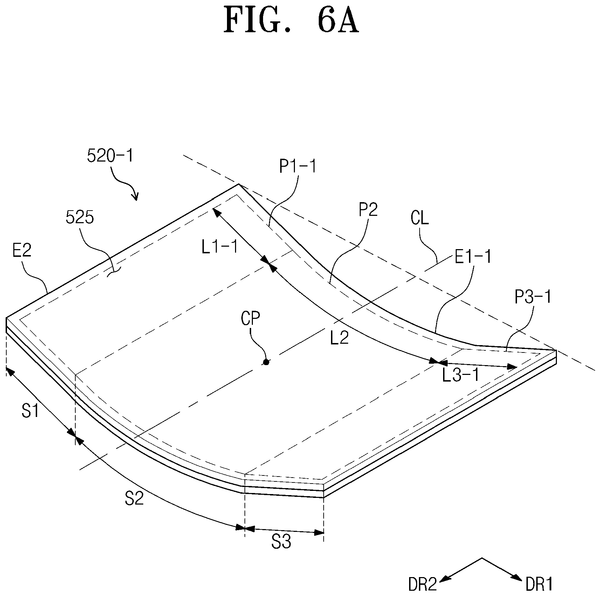

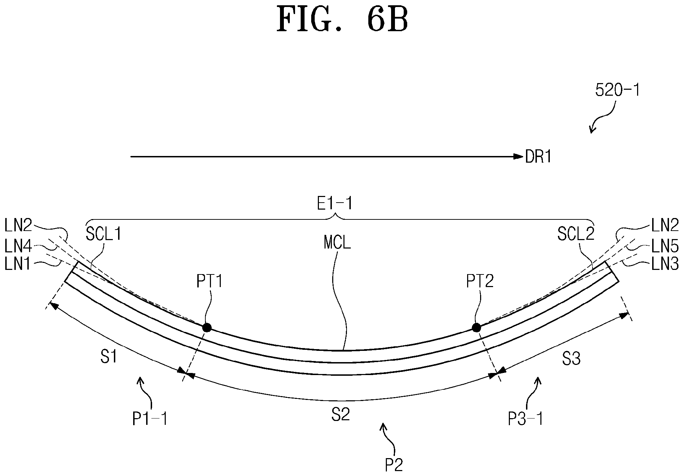

Fig. 6A is a perspective view illustrating a display panel of a curved display device according to another embodiment of the present invention, and Fig. 6B is a side view illustrating the display panel shown in Fig. 6A. Herein, components described above are denoted by like reference numerals, and duplicative description of these components are not provided.

Referring to Figs. 6A and 6B, a display panel 520-1 is curved, with a long side E1-1 of the display panel 520-1 is curved (e.g. concave) along the first direction DR1. A short side E2 of the display panel 520-1 is a straight line and extends along a second direction DR2 that is perpendicular to the first direction DR1.

In this embodiment, the display panel 520-1 may include a curved portion P2 having a first curvature radius in a second segment S2, a first subsidiary curved portion P1-1 in a first segment S1, and a second subsidiary curved portion P3-1 in a third segment S3, the first and second subsidiary curved portions P1-1 and P3-1 both having a second curvature radius, larger than the first curvature radius.

In one embodiment, the long side E1-1 sequentially includes a first subsidiary curved line SCL1 in the first segment S1, a middle curved line MCL in the second segment S2, and a second subsidiary curved line SCL2 in the third segment S3. The middle curved line MCL has the first curvature radius, and the first and second subsidiary curved lines SCL1 and SCL2 each have the second curvature radius.

In one embodiment, the second curvature radius may be larger than the first curvature radius. For example and without limitation, the first curvature radius may be 1m to 10m, and the second curvature radius may be 5 to 100,000 times as large as the first curvature radius.

In one embodiment, the first imaginary line LN1, the second imaginary line LN2 and the third imaginary line LN3 may be as they were defined with reference to Figs. 3A and 3B. However, since the first and second subsidiary curved portions P1-1 and P3-1 each have curvature radius larger than that of the first flat portion (element P1 of Fig. 3B) or the second flat portion (element P3 of Fig. 3B), a first imaginary curved line LN4 extending from the first subsidiary curved line SCL1 may be positioned between the first and second imaginary lines LN1 and LN2 and a second imaginary curved line LN5 extending from the second subsidiary curved line SCL2 may be positioned between the second and third imaginary lines LN2 and LN3.

In the embodiment where a first length L1-1 is the length of the first segment S1, a second length L2 is the length of the second segment S2, and a third length L3-1 is the length of the third segment S3, each ratio of the first and third lengths L1-1 and L3-1 to a sum of the first through third lengths L1-1, L2 and L3-1 may be about 1% through about 35%, and in some embodiments about 10% through about 25%. The reasons for defining the ratios within the aforementioned range can be understood by referring to the explanation provided in conjunction with Figs. 3A and 3B.

In one embodiment, the display panel 520-1 may be symmetrical with respect to the center line CL. Accordingly, the first subsidiary curved portion P1-1 may be symmetrical to the second subsidiary curved portion P3-1, with the curved portion P2 between the first subsidiary curved portion P1-1 and the second subsidiary curved portion P3-1, and then the first length L1-1 may be identical to the third length L3-1.

Since in this embodiment, the curvature radii of the first and second subsidiary curved portions P1-1 and P3-1 of the display panel 520-1 are each larger than the curvature radius of the curved portion P2, the first and second subsidiary curved portions P1-1 and P3-1 may contribute to reducing physical stress that may be exerted on both edges of the display panel 520-1, similar to the effect provided by the first and second flat portions (elements P1 and P3 of Fig. 3A). As a result, optical retardation of light transmitted through the edges of the display panel 520-1 can be inhibited (or reduced), and display quality of the display panel 520-1 can be prevented (or reduced) from deterioration.

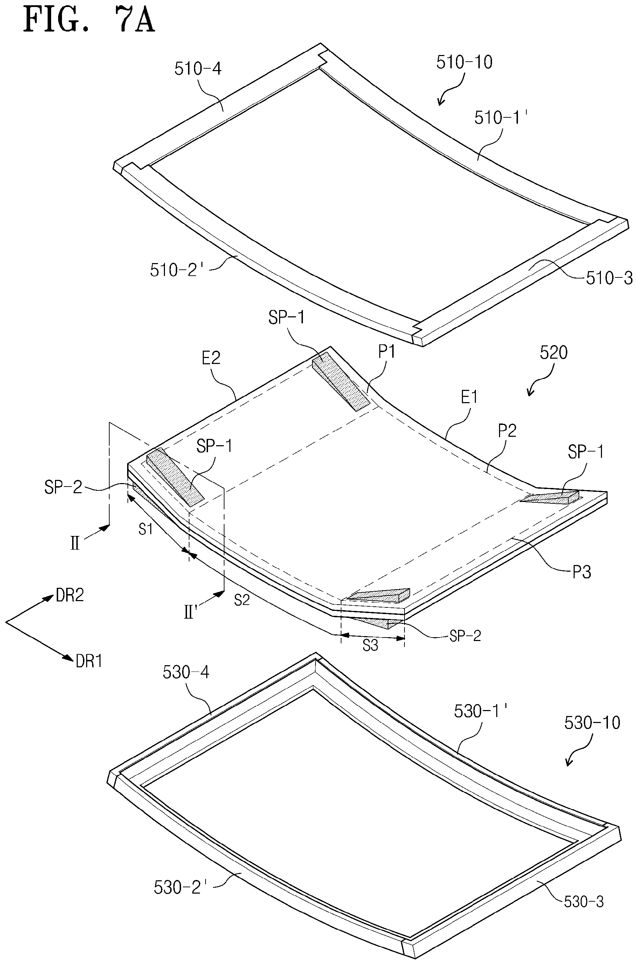

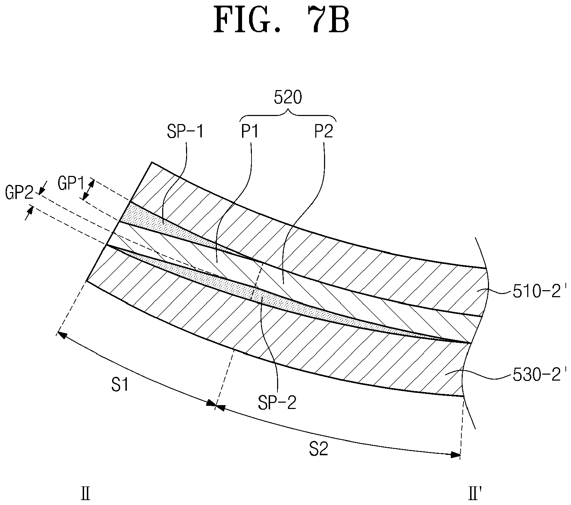

Fig. 7A is a disassembled perspective view illustrating how a display panel, a supporter, and a cover in a curved display device not according to the invention can be combined, and Fig. 7B is a sectional view taken along line II-II' of Fig. 7A. Herein, components described above are denoted by like reference numerals, and duplicative description of these components are not provided..

Referring to Figs. 7A and 7B, a curved display device includes first spacers SP-1 and second spacers SP-2.

In this example a cover 510-10 and a supporter 530-10 may extend in the first direction DR1 and may be uniformly curved along the first direction DR1 throughout the first through third segments S1 to S3. In other words, the entirety of each of the cover 510-10 and the supporter 530-10 may have the same curvature radius as that of the curved portion P2 of the display panel 520.

In one embodiment, unlike the cover 510-10 and the supporter 530-10, the display panel 520 is not entirely curved, but instead includes the first and second flat portions P1 and P3 in the first and third segments S1 and S3. Accordingly, near a border between the first and second segments S1 and S2 and/or a border between the second and third segments S2 and S3, there may be gaps above and below the display panel 520. In further detail, as shown in Fig. 7B, there may be a first gap GP1 in the first segment S1 between the display panel 520 and a second cover member 510-2' of the cover 510-10 and a second gap GP2 in each of the first and second segments S1 and S2 between the display panel 520 and a second support member 530-2' of the supporter 530-10. In one embodiment, the first spacer SP-1 is accommodated into the first gap GP1 and the second spacer SP-2 is accommodated into the second gap GP2. In Fig. 7A, the configuration of a first cover member 510-1' of the cover 510-10 and a first support member 530-1' of the supporter 530-10 are the same as the configuration of the second cover member 510-2' of the cover 510-10 and the second support member 530-2' of the supporter 530-10. Thus, duplicative description is omitted.

As a result, a contact area between the cover 510-10, the display panel 520 and the supporter 530-10 can be increased due to the first and second spacers SP-1 and SP-2, thus providing a stronger support to both flat and curved regions of the structure.

In one embodiment, the first and second spacers SP-1 and SP-2 may contain an elastic material such as silicon and rubber, or may be made of double-faced tapes, but materials for forming the first and second spacers SP-1 and SP-2 are not limited thereto.

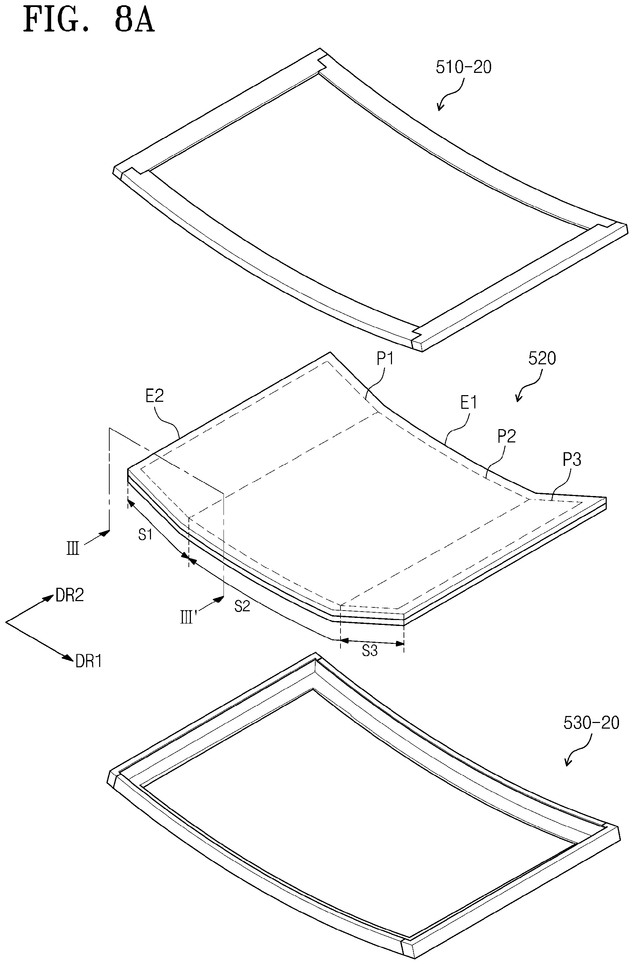

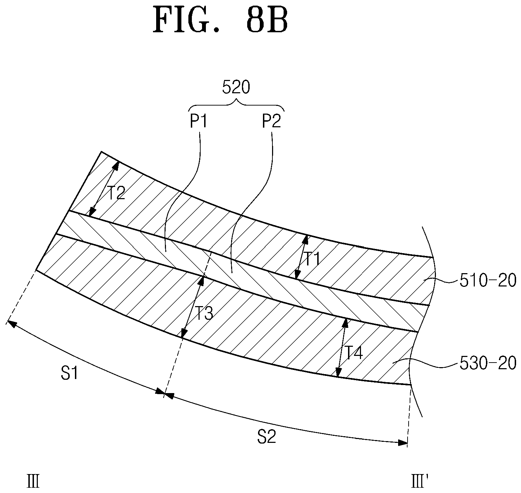

Fig. 8A is a disassembled perspective view illustrating how a display panel, a supporter, and a cover in a curved display device according to another embodiment of the present invention can be combined, and Fig. 8B is a sectional view taken along line III-III' of Fig. 8A. Herein, components described above are denoted by like reference numerals and duplicative description of these components are not provided..

Referring to Figs. 8A and 8B, similar to the embodiment illustrated in Figs. 7A and 7B and described above, a cover 510-20 and a supporter 530-20 may be uniformly curved throughout the first through third segments S1 to S3. The curvature radii of the cover 510-20 and the supporter 530-20 may be the same as that of the curved portion P2 of the display panel 520.

In this embodiment, unlike the cover 510-20 and the supporter 530-20, the display panel 520 is not entirely curved, but instead includes the first and second flat portions P1 and P3 in the first and third segments S1 and S3. In one embodiment, the supporter 530-20 and the cover 510-20 may each have variable thickness, thus improving their adherence to the display panel 520 near the borders between the first and second segments S1 and S2 and the second and third segments S2 and S3.

In this embodiment, a first thickness T1 of the part of the cover 510-20 corresponding to the second segment S2 may be smaller than a second thickness T2 of the part of the cover 510-20 corresponding to the first segment S1. Additionally, a third thickness T3 of the part of the supporter 530-20 corresponding to the border between the first and second segments S1 and S2 may be larger than a fourth thickness T4 of the part of the supporter 530-20 towards the middle of the second segment S2.

Since a contact area between the cover 510-20, the display panel 520 and the supporter 530-20 can be increased if the cover 510-20 and the supporter 530-20 have the aforementioned structure, the cover 510-20 and the supporter 530-20 may provide for a stronger support of both the flat and curved regions of the display panel 520.

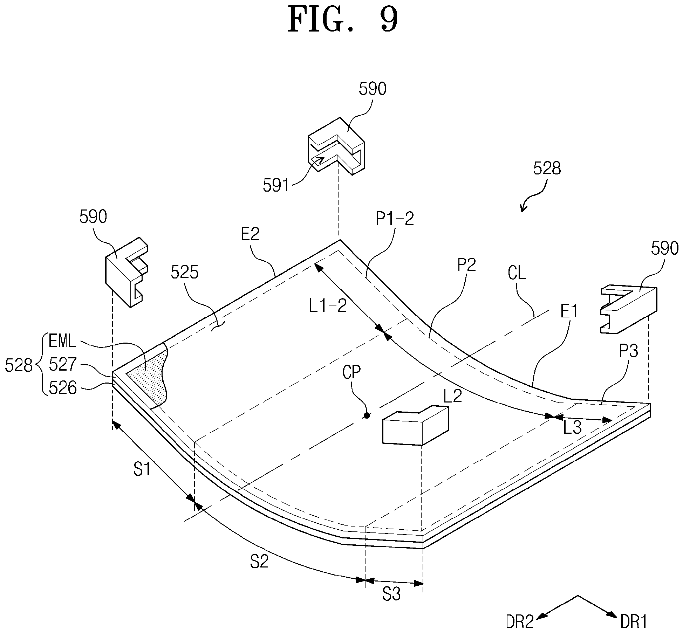

Fig. 9 is a perspective view illustrating a display panel of a curved display device according to another embodiment of the present invention. Herein, components described above are denoted by like reference numerals and duplicative descriptions of these components are not provided.

Referring to Fig. 9, a display panel 528 of a curved display device includes a first flat portion P1-2 in the first segment S1, a curved portion P2 in the second segment S2, and a second flat portion P3 in the third segment S3.

In this embodiment, the first flat portion P1-2 and the second flat portion P3, between which the curved portion P2 is positioned, are not symmetrical. In particular, the first flat portion P1-2 may be larger than the second flat portion P3, and a first length L1-2 of the first segment S1 may be longer than a third length L3 of the third segment S3.

Similar to the embodiments described above, here, the each ratio of the first and third lengths L1-2 and L3 to a sum of the first through third lengths L1-2, L2 and L3 is defined as a straight segment ratio, and may be about 1% to about 35%, or about 10% to about 25%. The reasons for defining the straight segment ratio within the above ranges can be understood by referring to the explanation provided in conjunction with Figs. 3A and 3B.

In this embodiment, subsidiary supporters 590 coupled to the corners of the display panel 528 may be further provided. The subsidiary supporters 590 may include grooves 591 into which the corners of the display panel 528 can be inserted. After the corners of the display panel 528 are inserted into the grooves 591, improved support for the configuration of the first and second flat portions P1-2 and P3 may be provided.

In one embodiment, the display panel 528 may be an organic electric-field light emission display panel. In this case, the display panel 528 may include a first substrate 526 including an organic light emission layer EML, and a second substrate 527 coupled with the first substrate 526. The organic light emission layer EML may be positioned between the first and second electrodes (not shown) included in the first substrate 526. In this embodiment, the first substrate 526 may be glass or plastic. The second substrate 527 may be a sack kind capable of sealing the organic light emission layer EML therein, thus protecting the organic light emission layer EML from the outside environment.

In embodiments of the present invention, the center of the display panel of the curved display device is curved, and the edges of the display panel are either flat or curved such that the curvature radii of the edges are each larger than the center curvature radius. Accordingly, stress that may concentrate on the edges of the display panel may be prevented (or reduced), thus improving the quality of the display panel.

Additionally, when the ratio of the straight segment to the total length of the display panel is within the ranges described above, luminance of the light source caused by the stress in the display panel may be minimized (or reduced), thus minimizing (or reducing) the appearance of a light source in the display area of the curved display device. Accordingly, the image in the display area can have improved contrast.

When the ratio of the straight segment to the total length of the display panel is within the scope of the embodiments of the present invention, luminance of the light source can be lowered, and, since this luminance is defined as a reference level for evaluating display quality of a curved display device, unsatisfactory display panels can be discarded, and as a result, a curved display device with an improved contrast ratio may be realized.

## Claims

1. A curved display device (600) comprising:
a display panel (520) sequentially including a first segment (S1), a second segment (S2) and a third segment (S3), and further comprising a display area (DA),
wherein the display panel (520) is curved along a first direction (DR1), the second segment (S2) has a first curvature radius, and the first (S1) and third segments (S3) are flat
**characterized in that**
each ratio of the first segment (S1) and the third segment (S3) to a sum of the first, second, and third segments (S1, S2, S3) in length along a long side (E1) is about 1% to about 35%, and
the first through third segments (S1 to S3) are sequentially along the long side (E1) of the display panel (520),
wherein the long side (E1) defines a first straight line (SL1) in the first segment (S1), a curved line having the first curvature radius in the second segment (S2), and a second straight line (SL2) in the third segment (S3),
wherein the curved line meets the first straight line (SL1) at a first point (PT1) and the second straight line (SL2) at a second point (PT2), and
wherein an imaginary curved line (LN2) having the first curvature radius extends from each of the first and second points (PT1, PT2), and the first straight line (SL1) is tangent to the imaginary curved line (LN2) at the first point (PT1) between the curved line and the imaginary curved line and the second straight line (SL2) is tangent to the imaginary curved line (LN2) at the second point (PT2) between the curved line and the second imaginary curved line (LN2), opposite the first point (PT1),
the display panel (520) comprises two long sides (E1) and two short sides (E2) and the sequence of curved and flat segments is provided along the long side (E1) of the display panel (520).

2. The curved display device (600) according to claim 1, wherein each ratio of the first segment (S1) and the third segment (S3) to the sum of the first, second, and third segments (S1, S2, S3) in length along the long side (E1) is about 10% to about 25%.

3. The curved display device (600) according to claim 1, wherein the first flat portion (P1) is symmetrical to the second flat portion (P2), and the curved portion is between the first flat portion (P1) and the second flat portion (P2).

4. The curved display device (600) according to claim 3, wherein a length of the first segment (S1) is the same as a length of the third segment (S3).

5. The curved display device (600) according to claim 1, wherein the first flat portion (P1) is asymmetrical to the second flat portion (P2), and the curved portion is between the first flat portion (P1) and the second flat portion (P2).

6. The curved display device (600) according to claim 5, wherein a length of the first segment (S1) is different from a length of the third segment (S3).

7. The curved display device (600) according to claim 1, wherein the display panel (520) comprises:
a pair of glass substrates (521, 522) coupled with each other

8. The curved display device (600) according to claim 1, wherein the display area (DA) is concaved in the second segment (S2).

9. The curved display device according to claim 1, further comprising:
a subsidiary supporter coupled with at least one corner of the display panel (520).

10. The curved display device (600) according to claim 1, further comprising a supporter (530) coupled with the display panel (520), the supporter being curved along the first direction (DR1) in a region corresponding to the second segment (S2) and being flat in regions corresponding to the first and third segments (S1, S3) respectively.

11. The curved display device (600) according to claim 10, further comprising a cover (510) covering the display panel (520) and having an opening corresponding to the display area (DA),
wherein the cover (510) is curved along the first direction (DR1) in a region corresponding to the second segment (S2) and is flat in a region corresponding to the first and third segments (S1,S3) respectively.

12. The curved display device (600) according to claim 11, wherein the supporter (530) and the cover (510) respectively have the first curvature radius in the regions corresponding to the second segment (S2).

13. The curved display device (600) according to claim 1, further comprising:
a supporter (530) coupled with the display panel (520); and
a cover (510) covering the display panel (520) and having an opening corresponding to the display area (DA),
wherein the supporter (530) and the cover are respectively curved along the first direction (DR1) in regions corresponding to the first through third segments (S1, S3).

14. The curved display device (600) according to claim 13, further comprising:
a plurality of first spacers accommodated in gaps between the cover (510) and the display panel (520) and, at least one of the plurality of first spacers being adjacent to a border between the first and second segments (S1, S2) and a border between the second and third segments (S2, S3) and making contact with the display panel (520) and the cover (510); and
a plurality of second spacers accommodated in gaps between the supporter (530) and the display panel (520), at least one of the plurality of second spacers being adjacent to the border between the first and second segments (S1, S2) and the border between the second and third segments (S2, S3) and making contact with the supporter and the display panel (520).

15. The curved display device (600) according to claim 13, wherein a thickness of a part of at least one of the supporter (530) and the cover (510) at each of the borders between the first and second segments (S1, S2) and between the second and third segments (S2, S3) is different from a thickness of a second part of at least one of the supporter (530) and the cover (510), at least one of the supporter (530) and the cover (510) contacting the curved portion and the second flat portion of the display panel (520).

## Patentansprüche

1. Gebogene Anzeigevorrichtung (600), die Folgendes umfasst:
eine Anzeigetafel (520), die ein erstes Segment (S1), ein zweites Segment (S2) und ein drittes Segment (S3) aufeinanderfolgend beinhaltet und die ferner eine Anzeigefläche (display area - DA) umfasst,
wobei die Anzeigetafel (520) entlang einer ersten Richtung (DR1) gebogen ist,
wobei das zweite Segment (S2) einen ersten Krümmungsradius aufweist und das erste (S1) und das dritte Segment (S3) flach sind,
**dadurch gekennzeichnet, dass**
jedes Verhältnis des ersten Segments (S1) und des dritten Segments (S3) zu einer Summe des ersten, zweiten und dritten Segments (S1, S2, S3) in Länge entlang einer langen Seite (E1) etwa 1 % bis etwa 35 % ist, und
das erste bis dritte Segment (S1 bis S3) entlang der langen Seite (E1) der Anzeigetafel (520) aufeinanderfolgen,
wobei die lange Seite (E1) eine erste gerade Linie (SL1) in dem ersten Segment (S1) definiert, wobei eine gebogene Linie den ersten Krümmungsradius in dem zweiten Segment (S2) und eine zweite gerade Linie (SL2) in dem dritten Segment (S3) aufweist,
wobei die gebogene Linie die erste gerade Linie (SL1) an einem ersten Punkt (PT1) und die zweite gerade Linie (SL2) an einem zweiten Punkt (PT2) trifft, und wobei sich eine imaginäre gebogene Linie (LN2), die den ersten Krümmungsradius aufweist, von jedem von dem ersten und zweiten Punkt (PT1, PT2) erstreckt und die erste gerade Linie (SL1) die imaginäre gebogene Linie (LN2) an dem ersten Punkt (PT1) zwischen der gebogenen Linie und der imaginären gebogenen Linie (LN2) berührt und die zweite gerade Linie (SL2) die imaginäre gebogene Linie (LN2) an dem zweiten Punkt (PT2) zwischen der gebogenen Linie und der zweiten imaginären gebogenen Linie (LN2) gegenüber dem ersten Punkt (PT1) berührt, die Anzeigetafel (520) zwei lange Seiten (E1) und zwei kurze Seiten (E2) umfasst und die Sequenz von gebogenen und flachen Segmenten entlang der langen Seite (E1) der Anzeigetafel (520) bereitgestellt wird.

2. Gebogene Anzeigevorrichtung (600) nach Anspruch 1, wobei jedes Verhältnis des ersten Segments (S1) und des dritten Segments (S3) zu der Summe des ersten, zweiten und dritten Segments (S1, S2, S3) in der Länge entlang der langen Seite (E1) etwa 10 % bis etwa 25 % ist.

3. Gebogene Anzeigevorrichtung (600) nach Anspruch 1, wobei der erste flache Abschnitt (P1) symmetrisch zu dem zweiten flachen Abschnitt (P2) ist und der gekrümmte Abschnitt zwischen dem ersten flachen Abschnitt (P1) und dem zweiten flachen Abschnitt (P2) liegt.

4. Gebogene Anzeigevorrichtung (600) nach Anspruch 3, wobei eine Länge des ersten Segments (S1) die gleiche ist wie eine Länge des dritten Segments (S3).

5. Gebogene Anzeigevorrichtung (600) nach Anspruch 1, wobei der erste flache Abschnitt (P1) asymmetrisch zu dem zweiten flachen Abschnitt (P2) ist und der gebogene Abschnitt zwischen dem ersten flachen Abschnitt (P1) und dem zweiten flachen Abschnitt (2) liegt.

6. Gebogene Anzeigevorrichtung (600) nach Anspruch 5, wobei eine Länge des ersten Segments (S1) unterschiedlich zu einer Länge des dritten Segments (S3) ist.

7. Gebogene Anzeigevorrichtung (600) nach Anspruch 1, wobei die Anzeigetafel (520) Folgendes umfasst:
ein Paar von Glassubstraten (521, 522), die miteinander gekoppelt sind.

8. Gebogene Anzeigevorrichtung (600) nach Anspruch 1, wobei die Anzeigefläche (DA) in dem zweiten Segment (S2) konkav ausgebildet ist.

9. Gebogene Anzeigevorrichtung nach Anspruch 1, die ferner Folgendes umfasst:
einen Unterträger, der mit mindestens einer Ecke der Anzeigetafel (520) gekoppelt ist.

10. Gebogene Anzeigevorrichtung (600) nach Anspruch 1, die ferner einen Träger (530) umfasst, der mit der Anzeigetafel (520) gekoppelt ist, wobei der Träger entlang der ersten Richtung (DR1) in einem Bereich gebogen ist, der dem zweiten Segment (S2) entspricht, und in Bereichen flach ist, die dem ersten bzw. dritten Segment (S1, S3) entsprechen.

11. Gebogene Anzeigevorrichtung (600) nach Anspruch 10, die ferner eine Abdeckung (510) umfasst, welche die Anzeigetafel (520) abdeckt und eine Öffnung aufweist, die der Anzeigefläche (DA) entspricht,
wobei die Abdeckung (510) entlang der ersten Richtung (DR1) in einem Bereich gebogen ist, der dem zweiten Segment (S2) entspricht, und in einem Bereich flach ist, der dem ersten bzw. dritten Segment (S1, S3) entspricht.

12. Gebogene Anzeigevorrichtung (600) nach Anspruch 11, wobei der Träger (530) bzw. die Abdeckung (510) den ersten Krümmungsradius in den Bereichen aufweisen, die dem zweiten Segment (S2) entsprechen.

13. Gebogene Anzeigevorrichtung (600) nach Anspruch 1, die ferner Folgendes umfasst:
einen Träger (530), der mit der Anzeigetafel (520) gekoppelt ist; und
eine Abdeckung (510), welche die Anzeigetafel (520) abdeckt und eine Öffnung aufweist, die der Anzeigefläche (DA) entspricht,
wobei der Träger (530) und die Abdeckung jeweils entlang der ersten Richtung (DR1) in Bereichen gebogen sind, die dem ersten bis dritten Segment (S1, S3) entsprechen.

14. Gebogene Anzeigevorrichtung (600) nach Anspruch 13, die ferner Folgendes umfasst:
eine Vielzahl von ersten Abstandhaltern, die in Zwischenräumen zwischen der Abdeckung (510) und der Anzeigetafel (520) aufgenommen sind, und wobei mindestens einer der Vielzahl von ersten Abstandhaltern benachbart zu einer Grenze zwischen dem ersten und zweiten Segment (S1, S2) und einer Grenze zwischen dem zweiten und dritten Segment (S2, S3) liegt und in Kontakt mit der Anzeigetafel (520) und der Abdeckung (510) steht; und
eine Vielzahl von zweiten Abstandhaltern, die in Zwischenräumen zwischen dem Träger (530) und der Anzeigetafel (520) aufgenommen sind, wobei mindestens einer der Vielzahl von zweiten Abstandhaltern benachbart zu der Grenze zwischen dem ersten und zweiten Segment (S1, S2) und der Grenze zwischen dem zweiten und dritten Segment (S2, S3) liegt und in Kontakt mit dem Träger und der Anzeigetafel (520) steht.

15. Gebogene Anzeigevorrichtung (600) nach Anspruch 13, wobei eine Dicke eines Teils von mindestens einem des Trägers (530) und der Abdeckung (510) an jeder der Grenzen zwischen dem ersten und zweiten Segment (S1, S2) und zwischen dem zweiten und dritten Segment (S2, S3) unterschiedlich zu einer Dicke eines zweiten Teils von mindestens einem des Trägers (530) und der Abdeckung (510) ist, wobei mindestens einer des Trägers (530) und der Abdeckung (510) den gebogenen Abschnitt und den zweiten flachen Abschnitt der Anzeigetafel (520) berührt.

## Revendications

1. Dispositif d'affichage incurvé (600) comprenant :
un écran d'affichage (520) incluant séquentiellement un premier segment (S1), un deuxième segment (S2) et un troisième segment (S3), et comprenant en outre une zone d'affichage (DA),
dans lequel l'écran d'affichage (520) est incurvé suivant une première direction (DR1), le deuxième segment (S2) a un premier rayon de courbure, et les premier (S1) et troisième (S3) segments sont plats
**caractérisé en ce que**
chaque rapport du premier segment (S1) et du troisième segment (S3) sur une somme des premier, deuxième et troisième segments (S1, S2, S3) en longueur le long d'un côté long (E1) est d'environ 1 % à environ 35 %, et
les premier à troisième segments (S1 à S3) sont séquentiellement le long du côté long (E1) de l'écran d'affichage (520),
dans lequel le côté long (E1) définit une première ligne droite (SL1) dans le premier segment (S1), une ligne incurvée ayant le premier rayon de courbure dans le deuxième segment (S2), et une seconde ligne droite (SL2) dans le troisième segment (S3),
dans lequel la ligne incurvée rencontre la première ligne droite (SL1) en un premier point (PT1) et la seconde ligne droite (SL2) en un second point (PT2), et
dans lequel une ligne incurvée imaginaire (LN2) ayant le premier rayon de courbure s'étend depuis chacun des premier et second points (PT1, PT2), et la première ligne droite (SL1) est tangente à la ligne incurvée imaginaire (LN2) en le premier point (PT1) entre la ligne incurvée et la ligne incurvée imaginaire, et la seconde ligne droite (SL2) est tangente à la ligne incurvée imaginaire (LN2) en le second point (PT2) entre la ligne incurvée et la seconde ligne incurvée imaginaire (LN2), opposé au premier point (PT1),
l'écran d'affichage (520) comprend deux côtés longs (E1) et deux côtés courts (E2) et la séquence de segments incurvés et plats est prévue le long du côté long (E1) de l'écran d'affichage (520).

2. Dispositif d'affichage incurvé (600) selon la revendication 1, dans lequel chaque rapport du premier segment (S1) et du troisième segment (S3) sur la somme des premier, deuxième et troisième segments (S1, S2, S3) en longueur le long du côté long (E1) est d'environ 10 % à environ 25 %.

3. Dispositif d'affichage incurvé (600) selon la revendication 1, dans lequel la première portion plate (P1) est symétrique à la seconde portion plate (P2), et la portion incurvée est entre la première portion plate (P1) et la seconde portion plate (P2).

4. Dispositif d'affichage incurvé (600) selon la revendication 3, dans lequel une longueur du premier segment (S1) est la même qu'une longueur du troisième segment (S3).

5. Dispositif d'affichage incurvé (600) selon la revendication 1, dans lequel la première portion plate (P1) est asymétrique à la seconde portion plate (P2), et la portion incurvée est entre la première portion plate (P1) et la seconde portion plate (P2).

6. Dispositif d'affichage incurvé (600) selon la revendication 5, dans lequel une longueur du premier segment (S1) est différente d'une longueur du troisième segment (S3).

7. Dispositif d'affichage incurvé (600) selon la revendication 1, dans lequel l'écran d'affichage (520) comprend :
une paire de substrats en verre (521, 522) accouplés l'un à l'autre.

8. Dispositif d'affichage incurvé (600) selon la revendication 1, dans lequel la zone d'affichage (DA) est concave dans le deuxième segment (S2).

9. Dispositif d'affichage incurvé selon la revendication 1, comprenant en outre :
un élément de support auxiliaire accouplé à au moins un coin de l'écran d'affichage (520).

10. Dispositif d'affichage incurvé (600) selon la revendication 1, comprenant en outre un élément de support (530) accouplé à l'écran d'affichage (520), l'élément de support étant incurvé suivant la première direction (DR1) dans une région correspondant au deuxième segment (S2) et étant plat dans des régions correspondant aux premier et troisième segments (S1, S3) respectivement.

11. Dispositif d'affichage incurvé (600) selon la revendication 10, comprenant en outre un élément couvrant (510) couvrant l'écran d'affichage (520) et ayant une ouverture correspondant à la zone d'affichage (DA),
dans lequel l'élément couvrant (510) est incurvé suivant la première direction (DR1) dans une région correspondant au deuxième segment (S2) et est plat dans une région correspondant aux premier et troisième segments (S1, S3) respectivement.

12. Dispositif d'affichage incurvé (600) selon la revendication 11, dans lequel l'élément de support (530) et l'élément couvrant (510) ont respectivement le même rayon de courbure dans les régions correspondant au deuxième segment (S2).

13. Dispositif d'affichage incurvé (600) selon la revendication 1, comprenant en outre :
un élément de support (530) accouplé à l'écran d'affichage (520) ; et
un élément couvrant (510) couvrant l'écran d'affichage (520) et ayant une ouverture correspondant à la zone d'affichage (DA),
dans lequel l'élément de support (530) et l'élément couvrant sont incurvés respectivement suivant la première direction (DR1) dans des régions correspondant aux premier à troisième segments (S1, S3).

14. Dispositif d'affichage incurvé (600) selon la revendication 13, comprenant en outre :
une pluralité de premiers espaceurs logés dans des écartements entre l'élément couvrant (510) et l'écran d'affichage (520) et, au moins l'un de la pluralité de premiers espaceurs étant adjacents à une limite entre les premier et deuxième segments (S1, S2) et une limite entre les deuxième et troisième segments (S2, S3) et établissant un contact avec l'écran d'affichage (520) et l'élément couvrant (510) ; et
une pluralité de seconds espaceurs logés dans des écartements entre l'élément de support (530) et l'écran d'affichage (520), au moins l'un de la pluralité de seconds espaceurs étant adjacent à la limite entre les premier et deuxième segments (S1, S2) et la limite entre les deuxième et troisième segments (S2, S3) et établissant un contact avec l'élément de support et l'écran d'affichage (520).

15. Dispositif d'affichage incurvé (600) selon la revendication 13, dans lequel une épaisseur d'une partie d'au moins l'un de l'élément de support (530) et de l'élément couvrant (510) au niveau de chacune des limites entre les premier et deuxième segments (S1, S2) et entre les deuxième et troisième segments (S2, S3) est différente d'une épaisseur d'une seconde partie d'au moins l'un de l'élément de support (530) et de l'élément couvrant (510), au moins l'un de l'élément de support (530) et de l'élément couvrant (510) entrant en contact avec la portion incurvée et la seconde plate de l'écran d'affichage (520).
